Europäisches Patentamt

European Patent Office

Office européen des brevets

(11) Publication number: **0 388 957**
**A2**

# (12) EUROPEAN PATENT APPLICATION

(21) Application number: **90105440.3**

(22) Date of filing: **22.03.90**

(51) Int. Cl.⁵: **H01L 21/316, C23C 16/40, C23C 16/50**

(30) Priority: **22.03.89 JP 71206/89**

(43) Date of publication of application:
**26.09.90 Bulletin 90/39**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Kamiyama, Satoshi**
**c/o NEC Corporation, 33-1 Shiba 5-chome**
**Minato-ku, Tokyo(JP)**
Inventor: **Zenke, Masanobu**
**c/o NEC Corporation, 33-1 Shiba 5-chome**
**Minato-ku, Tokyo(JP)**

(74) Representative: **Glawe, Delfs, Moll & Partner**
**Patentanwälte**
**Postfach 26 01 62**
**D-8000 München 26(DE)**

(54) Process for depositing tantalum oxide film and chemical vapor deposition system used therefore.

(57) A process of depositing a tantalum oxide film starts with preparing a reactor (34) with a vacuum chamber (35) associated with a plasma generating unit (32), a tantalum chloride gas and an oxygen-containing gas such as a dinitrogen monoxide gas are supplied to the vacuum chamber, and a plasma is produced in the vacuum chamber for plasma-assisted chemical reactions; a tantalum oxide film thus deposited decreases leakage current passing therethrough because the chemical composition thereof is close to the stoichiometry and undesirable pin holes and impurities are reduced.

FIG.2

EP 0 388 957 A2

## FIELD OF THE INVENTION

This invention relates to a chemical vapor deposition technique and, more particularly, to a chemical vapor deposition technique used in formation of a thin tantalum oxide film for providing an electrical insulation in a semiconductor device by way of example.

## DESCRIPTION OF THE RELATED ART

The minimum device dimension of an integrated circuit has been shrunk, and such a continuous scale down requests the dielectric film of, for example, a capacitor to be thinner and thinner. However, the conventional dielectric materials such as silicon oxide and silicon nitride reach the physical limit because direct tunneling current seriously takes place across the dielectric film. Therefore, research and development efforts are being made for a reliable insulating film with an emphasis put on a tantalum oxide films deposited through a chemical vapor deposition technique which is advantageous over a sputtered tantalum oxide film in coverage.

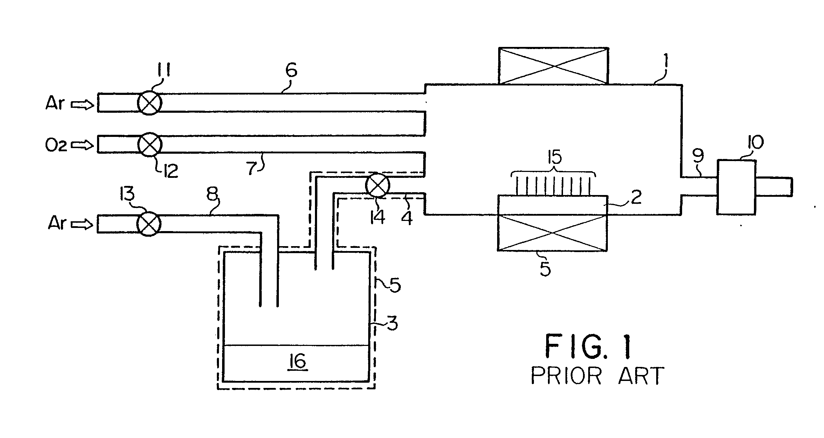

Referring first to Fig. 1 of the drawings, a prior art chemical vapor deposition system for tantalum oxide films comprises a quartz reactor 1 equipped therein with wafer holder 2, a bubbler 3 coupled through a gas tube 4 to the reactor 1, a heating system 5 for the reactor 1 and the bubbler 3 three gas inlet tubes 6, 7 and 8, a gas outlet tube 9 coupled to a vacuum pump 10, and valves 11, 12, 13 and 14 provided in the gas tubes 6, 7, 8 and 4, respectively. The wafer holder 2 retains a plurality of semiconductor wafers 15, and an organotantalum compound 16 such as penta-ethoxy-tantalum $(Ta(OC_2H_5)_5)$ or penta-methoxy-tantalum $((Ta(OCH_3)_5)$ is supplied to the bubbler 3. The vacuum pump 10 is activated and discharges gaseous mixture in the quartz reactor 1.

The heating system 5 increases the bubbler 3 and the quartz reactor 1 to respective certain temperatures, and a carrier gas of argon is guided through the gas inlet tube 8 to the bubbler 3. Then, the organotantaltum compound is vaporized and flows through the gas tube 4 into the reactor 1, and oxygen gas is further supplied to the quartz reactor 1. The organotantalum compound reacts with the oxygen around the semiconductor wafers 15, and tantalum oxide thus produced is deposited on the surfaces of the semiconductor wafers 15.

In this instance, the organotantalum compound is heated at 100 degrees to 200 degrees in centigrade, and the temperature in the quartz reactor 1 is fallen within a range from 200 degrees to 600 degrees in centigrade. The oxygen gas flow ranges from 0.1 SLM (Standard (state) Litter per Minute) to 5.0 SLM, and the carrier gas flow is regulated between 10 sccm (standard (state) c.c. per minute) to 200 sccm at 0.1 torr to 1.0 torr.

However, a problem is encountered in the prior art chemical vapor deposition technique in that a substantial amount of carbon is introduced in the tantalum oxide film deposited on the semiconductor wafer because the tantalum oxide is produced through the chemical reaction between the carbon containing organotantalum compound such as penta-ethoxy-tantalum $(Ta(OC_2H_5)_5)$ or penta-methoxy-tantalum $((Ta(OCH_3)_5)$ and oxygen. Moreover, a large number of pin holes take place in the tantalum oxide film, and the tantalum oxide tends to deviate from the stoichiometric composition toward a tantalum-rich oxide. Such a tantalum oxide is causative of a large amount of leakage current and, accordingly, is not reliable. In order to reduce the leakage current, the semiconductor wafer covered with the tantalum oxide film is placed in an electric furnace, and a high temperature heat treatment is carried out in a hydrogen-and-oxygen ambient at about 1000 degrees in centigrade. However, such a high temperature heat treatment varies impurity profiles previously formed in the semiconductor wafer, and, for this reason, it is hardly applicable for an ultra large scale integration.

## SUMMARY OF THE INVENTION

It is therefore an important object of the present invention to provide a process for depositing a tantalum oxide film which produces a fine tantalum oxide without undesirable carbon and pin holes.

It is another important object of the present invention to provide a chemical vapor deposition system which is used for depositing the fine tantalum oxide.

To accomplish these objects, the present invention proposes to form a tantalum oxide under a plasma-assisted chemical reaction between a tantalum chloride and a nitrogen oxide such as, for example, dinitrogen monoxide. The oxygen may be available.

In accordance with one aspect of the present invention, there is provided a process of depositing a tantalum oxide film comprising the steps of a) preparing a reactor with a vacuum chamber associated with a plasma generating unit, b) supplying the vacuum chamber with a tantalum chloride gas and an oxygen-containing gas selected from the group consisting of a dinitrogen monoxide gas represented by the molecular formula of $N_2O$, a nitrogen oxide gas represented by the molecular formula of NO and an oxygen gas represented by the molecular formula of $O_2$, and c) producing a plasma in the vacuum chamber so that plasma-assisted chemical reactions take place for a tantalum oxide.

In accordance with another aspect of the present invention, there is provided a chemical vapor deposition system for producing a tantalum oxide conprising a) a reactor unit having a vacuum chamber, b) a gas source unit coupled to the vacuum chamber for supplying a gaseous mixture containing a tantalum chloride and an oxygen-containing gas selected from the group consisting of a dinitrogen monoxide represented by the molecular formula of $N_2O$, a nitrogen oxide gas represented by the molecular formula of NO and an oxygen gas represented by the molecular formula of $O_2$, and c) a plasma generating unit producing a plasma in the gaseous mixture in the vacuum chamber.

BRIEF DESCRIPTION OF THE DRAWINGS

The features and advantages of a process and a system according to the present invention will be more clearly understood from the following description taken in conjunction with the accompanying drawings in which:

Fig. 1 is a schematic view showing the arrangement of a prior art chemical vapor deposition system;

Fig. 2 is a schematic view showing the arrangement of a chemical vapor deposition system according to the present invention;

Figs. 3A to 3C are cross sectional views showing a part of a process sequence for fabricating a semiconductor device; and

Fig. 4 is a graph showing the amount of leakage current in terms of the strength of electric field produced across the tantalum oxide films.

DESCRIPTION OF THE PREFERRED EMBODIMENTS

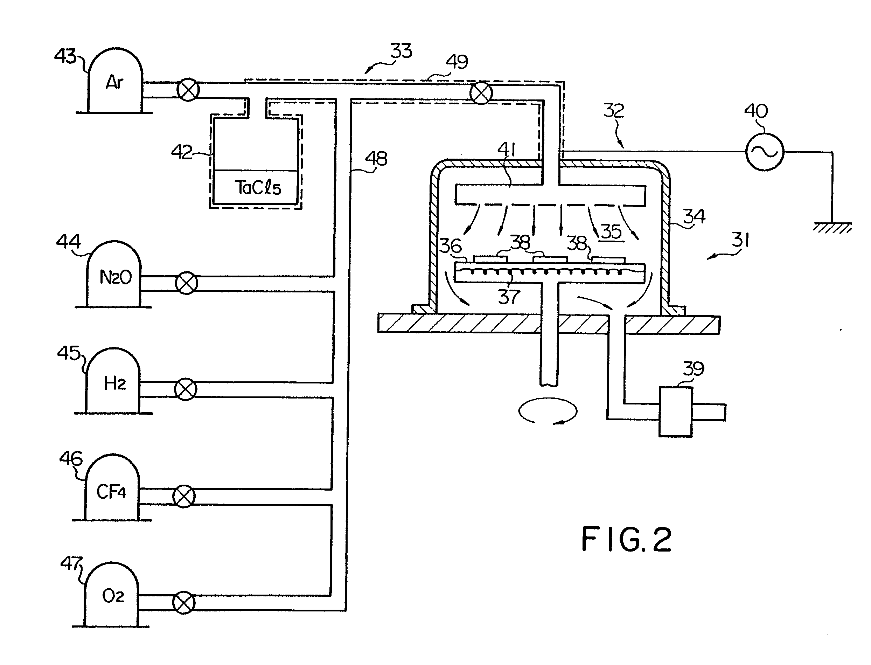

Referring first to Fig. 2 of the drawings, a chemical vapor deposition system according to the present invention largely comprises a reactor unit 31, a plasma generating unit 32 and a gaseous mixture supplying unit 33.

The reactor unit 31 has a reactor 34 with a vacuum chamber 35, and a wafer holder 36 accompanied with a heating element 37 projects into the vacuum chamber 35 for retaining semiconductor wafers 38.

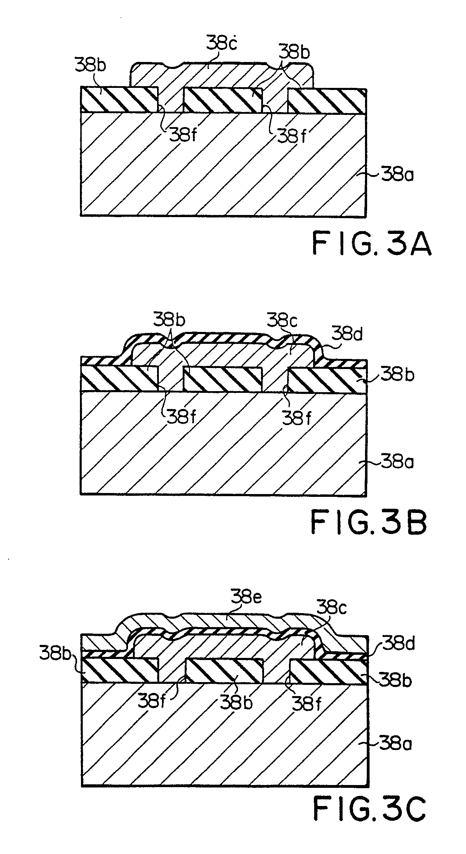

Each of the semiconductor wafers 38 has an intermediate structure on the way to an integration of semiconductor devices, and is, by way of example, implemented by a silicon substrate 38a partially covered with a silicon dioxide film 38b which in turn is partially covered with a phosphorus-doped polysilicon film 38c for a lower capacitor elec trode connected through contact holes 38f formed in the silicon dioxide film 38b to the substrate 38a as shown in Fig. 3A.

The vacuum chamber 35 is coupled to a vacuum pump unit 39 so that gaseous mixture is continuously evacuated from the vacuum chamber 35.

The plasma generating unit 32 has a high frequency electric power source 40 and is operative to produce plasma for promoting chemical reactions in the gaseous mixture.

The gaseous mixture supplying unit 33 has a gas outlet 41 projecting into the vacuum chamber 35, a vaporizer 42 for tantalum chloride ($TaCl_5$), an argon gas source 43, a dinitrogen monoxide gas source 44, a hydrogen gas source 45, a carbon tetrafluoride gas source 46, an oxygen gas source 47, a pipe network 48 with valve units selectively interconnecting the vaporizer 42, the gas sources 43 to 47 and the reactor 34, and a heating system 49 for the vaporizer 42 as well as the pipe network 48. The argon gas conducted into the vaporizer 42 serves as a carrier gas for conveying the tantalum chloride gas into the vacuum chamber 35.

A chemical vapor deposition process according to the present invention starts with vaporizing the tantalum chloride. Namely, the heating system 49 supplies heat to the tantalum chloride in the vaporizer 42, and the argon gas is guided from the source 43 into the vaporizer 42. The argon gas flow is about 10 sccm to about 200 sccm at 0.1 torr to 10.0 torr. The vaporized tantalum chloride is carried on the argon gas, and the gaseous mixture thereof is conducted toward the vacuum chamber 35. The dinitrogen monoxide gas is supplied from the source 44 to the pipe network 48, and is mixed into the gaseous mixture on the way to the vacuum chamber 34. In this instance, vaporizer 42 and the pipe between the vaporizer 42 and the reactor 34 are heated at about 50 degrees to about 200 degrees in centigrade, and the dinitrogen monoxide gas is regulated to about 0.1 SLM to about 5.0 SLM. The gaseous mixture containing the tantalum chloride, the argon and the dinitrogen monoxide flows into the vacuum chamber by the agency of vacuum created therein.

The heating element 37 increases the wafer holder 36 and, accordingly, the semiconductor wafers 38 in temperature, and the high frequency electric power source 40 allows plasma to be produced in the gaseous mixture containing the tantalum chloride, the argon and the dinitrogen monoxide thus supplied to the vacuum chamber 35. By virtue of the heating element 37, the vacuum chamber 35 is kept in a high temperature ambient ranging between about 100 degrees and about 600 degrees in centigrade. In this instance, the high frequency electric power source 40 produces an alternating current ranging from 50 kHz to 13.56 MHz at 30 watts to 500 watts. The process according to the present invention does not need an extremely high temperature ambient, and, for this reason, the heat is less affectable to impurity profiles formed in the semiconductor wafers 38.

A plasma-assisted chemical reaction takes place, and the tantalum chloride and the dinitrogen monoxide are rapidly dissolved. Since the tantalum reacts with the oxygen, a tantalum oxide is produced and deposited on the semiconductor wafers 38. Fig. 3B shows a tantalum oxide film 38d covering the polysilicon film 38c and provides a dielectric film of a capacitor. When the deposition stage is completed, a plate electrode 38e of a turgsten silicide is formed on the tantalum oxide film 38d as shown in Fig. 3C.

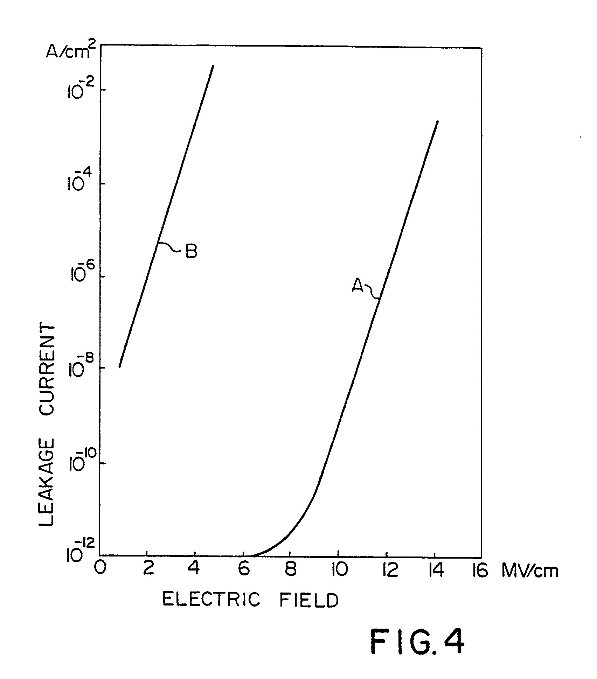

The tantalum oxide film produced through the process according to the present invention is evaluated in view of dielectric property. For comparison, a tantalum oxide film produced through the prior art process is also evaluated. Fig. 4 shows the amount of leakage current in terms of the strength of electric field across dielecric films, and Plots A and B respectively stand for the tantalum oxide film produced through the process according to the present invention (which is related to plots A) and the tantalum oxide film produced through the prior art process using the organotantalum compound. Comparing Plots A with Plots B, it will be understood that the tantalum oxide film produced through the process according to the present invention is advantageous in the dielectric property, and, accordingly, the amount of the leakage current is drastically decreased. The reasons why the leakage current is reduced are:

     a) the tantalum oxide film is subjected to bombardment of tantalum ions as well as oxygen ions during its formation due to the plasma-assisted chemical reactions and is, therefore, enhanced in density , and

     b) the tantalum chloride ($TaCl_5$) is less causative of pin holes and undesirable impurities such as carbon rather than organotantalum compound.

In fact, the tantalum oxide produced through the process according to the present invention has a composition closer to the stoichiometry of $Ta_2O_5$.

Prior to depositing the tantalum oxide film, the vacuum chamber 35 may be cleaned by using a fluorine containing halogen compound gas for removing residual chlorine from the vacuum chamber 35. In detail, a halogen compound gas such as carbon tetrafluoride ($CF_4$) is mixed into oxygen and guided to the vacuum chamber 35. The carbon tetrafluoride gas ranges from about 0.1 SLM to about 5.0 SLM, and the oxygen gas flow is about 0.1 SLM to about 2.0 SLM. The plasma is produced in the gas flow at 50 kHz to 13.56 MHz and about 30 watts to about 500 watts, then residual chlorine is washed away. If the deposition is carried out after the cleaning stage, the reproducibility is improved, and, accordingly, the thickness of the tantalum oxide film 38d is strictly controllable.

Another process according to the present invention is characterized by hydrogen gas which is further mixed into the gaseous mixture containing the tantalum chloride, the argon and the dinitrogen monoxide. The hydrogen gas flow ranges from about 0.1 SLM to about 3.0 SLM, and is conducive to reduction in the amount of undesirable impurities such as chlorine contained in the tantalum oxide film 38d. This is because of the fact that the hydrogen reacts with the chlorine when the tantalum chloride is dissolved into tantalum and chlorine. Thus, hydrogen gas used in the process according to the present invention further improves the tantalum oxide film in quality.

Still another process according to the present invention uses oxygen ($O_2$) and nitrogen oxide (NO).

As will be understood from the foregoing description, the process according to the present invention is desirable for producing a tantalum oxide film which is closer to the stoichiometric composition than that produced through the prior art process. Since the tantalum oxide film is high in density but small in the undesirable impurity content as well as in the number of pin holes, the tantalum oxide film produced through the process according to the present invention decreases the amount of leakage current flowing therethrough.

Although particular embodiments of the present invention have been shown and described, it will be obvious to those skilled in the art that various changes and modifications may be made without departing from the spirit and scope of the present invention. For example, the tantalum oxide film may be deposited on a substrate of single crystal silicon or of another semiconductor material, a silicide film such as, for example, a tungsten silicide, a polyside film (or a combination of a silicide film and a polysilicon film), a metallic nitride film such as a titanium nitride or a refractory metal film of, for example, tungsten. Further, the tantalum oxide film may be combined with a silicon dioxide film or a silicon nitride film to form a multi-level dielectric film structure such as, for example, a tantalum oxide/silicon dioxide film structure or a tantalum oxide/silicon nitride film structure which forms a part of a capacitor. Moreover, the plate electrode 38e may be formed of a refractory metal silicide film except for the tungsten silicide, a polysilicon film, a polyside film, or a metallic nitride film such as a tungsten nitride film.


## Claims

1. A process of depositing a tantalum oxide film comprising the steps of a) preparing a reactor with a vacuum chamber associated with a plasma generating unit, and b) supplying a gaseous mixture containing tantalum compound to said vacuum chamber, characterized in that said gaseous mixture contains a tantalum chloride ard an oxygen-containing gas selected from the group consisting of a dinitrogen monoxide represented by the molecular formula of $N_2O$, a nitrogen oxide gas represented by the molecular formula of NO and an oxygen gas represented by the molecular formula of $O_2$, and in that said process further comprises the step of c) producing a plasma in said vacuum chamber so that plasma-assisted chemical reactions take place for a tantalum oxide.

2. A process as set forth in claim 1, in which said oxygen-containing gas is said dinitrogen monoxide gas.

3. A chemical vapor deposition system for producing a tantalum oxide comprising a) a reactor unit having a vacuum chamber, b) a gas source unit coupled to said vacuum chamber for supplying a gaseous mixture, characterized in that said gaseous mixture contains a tantalum chloride and an oxygen-containing gas selected from the group consisting of a dinitrogen monoxide represented by the molecular formula of $N_2O$, a nitrogen oxide gas represented by the molecular formula of NO and an oxygen gas represented by the molecular formula of $O_2$, and in that said chemical vapor deposition system further comprises c) a plasma generating unit for producing a plasma in said gaseous mixture in said vacuum chamber.

FIG. 1
PRIOR ART

FIG.2

EP 0 388 957 A2

FIG. 3A

FIG. 3B

FIG. 3C

FIG.4